(19) Europäisches Patentamt European Patent Office Office européen des brevets

(11) **EP 1 272 863 B1**

(12) **FASCICULE DE BREVET EUROPEEN**

(45) Date de publication et mention de la délivrance du brevet:
**30.05.2007 Bulletin 2007/22**

(21) Numéro de dépôt: **01921515.1**

(22) Date de dépôt: **06.04.2001**

(51) Int Cl.:
*G01R 33/02* (2006.01)    *G01V 13/00* (2006.01)

(86) Numéro de dépôt international:
**PCT/FR2001/001061**

(87) Numéro de publication internationale:
**WO 2001/079873 (25.10.2001 Gazette 2001/43)**

(54) **DISPOSITIF ET PROCEDE DE MESURE DE CHAMP(S) MAGNETIQUE(S) A CALIBRATION SUPERPOSEE A LA MESURE, ET APPLICATIONS CORRESPONDANTES**

ANORDNUNG UND VERFAHREN ZUR MAGNETFELDMESSUNG MIT ÜBERLAGERTER KALIBRATION UND KORRESPONDIERENDEN ANWENDUNGEN

DEVICE AND METHOD FOR MEASURING MAGNETIC FIELD(S) WITH CALIBRATION SUPERIMPOSED ON THE MEASUREMENT, AND CORRESPONDING USES

(84) Etats contractants désignés:
**DE GB**

(30) Priorité: **14.04.2000 FR 0004860**

(43) Date de publication de la demande:
**08.01.2003 Bulletin 2003/02**

(73) Titulaire: **THALES AVIONICS S.A.**
**78140 Vélizy Villacoublay (FR)**

(72) Inventeur: **LESCOURRET, Jean-Louis,**
**Thomson-CSF Prop. Intelec.**
**F-94117 Arceuil Cedex (FR)**

(74) Mandataire: **Esselin, Sophie**
**Marks & Clerk France**
**31-33 Avenue Aristide Briand**
**94117 Arcueil Cedex (FR)**

(56) Documents cités:
**US-A- 4 613 866**        **US-A- 4 849 695**

**Description**

Le domaine de l'invention est celui de la mesure de champ(s) magnétique(s).

Plus précisément, l'invention concerne la mesure précise de champs magnétiques et en particulier la calibration des moyens de mesure mis en oeuvre.

Depuis toujours, l'obtention de mesures magnétiques de grande précision nécessite la mise en oeuvre de composants de précision, qui doivent présenter de grandes qualités de stabilité dans le temps (très faible dérive à long terme) et en température (très faible dérive thermique). En effet, les composants d'un circuit de mesure de courant par exemple, doivent avoir une précision au moins égale à, et de préférence meilleure, que celle requise pour la mesure.

Un inconvénient de cette technique de l'art antérieur est que ces composants de précision sont très onéreux.

Un autre inconvénient de cette technique de l'art antérieur est que ces composants doivent généralement être thermostatés et répondre à de sévères spécifications de vieillissement.

Un domaine privilégié de la présente invention est la détermination de l'orientation d'un système mobile par rapport à un référentiel, par exemple d'un viseur de casque utilisé dans les avions d'armes ou les hélicoptères de combat. Le fonctionnement d'un tel système est rappelé brièvement ci-après : par un dispositif collimateur annexe, le pilote voit, à travers sa visière semi-réfléchissante solidaire du casque, sur l'axe de vision, l'image d'un réticule projeté à l'infini en superposition avec la scène extérieure. Lorsqu'il veut désigner une cible, le pilote amène ce réticule à coïncider avec la cible et signale que la coïncidence est réalisée, au moyen par exemple d'une commande par bouton-poussoir, prévue à cet effet.

À condition de repérer, au moment de la signalisation, la position angulaire exacte du casque, il est possible de déterminer par rapport à l'avion, la direction de visée et de désigner l'objectif à un système d'arme, ou de pointer dans cette direction un système optique par exemple.

Un dispositif de mesure d'orientation et de position du casque du pilote dans un repère lié à l'aéronef peut consister en un capteur d'orientation et de position constitué de trois bobines électromagnétiques orthogonales et placé sur le casque, et en un émetteur, situé en un point fixe de la cabine, et constitué de trois autres bobines électromagnétiques. Le procédé consiste alors à faire passer, dans chaque bobine de l'émetteur (formant un trièdre sensiblement orthogonal fixe), un courant électrique. Ces courants font apparaître trois champs magnétiques qui sont captés par les bobines du capteur (formant un trièdre mobile sensiblement orthogonal lié au casque). L'analyse de ces champs magnétiques permet de déterminer la position et l'orientation du trièdre mobile par rapport au trièdre fixe.

Dans ce domaine d'application, il est impératif d'obtenir une mesure précise des champs magnétiques émis par l'émetteur fixe, et détectés par le capteur lié au casque, de manière à désigner avec précision, à un système d'arme, l'objectif sélectionné par le pilote.

Jusqu'à présent, on utilisait pour cette mesure des composants de grande précision, parfois thermostatés, pouvant fonctionner dans une large durée temporelle.

Un inconvénient de cette technique de l'art antérieur est que, même avec des composants de grande qualité et donc de complexité et de coût très élevés, il est difficile d'atteindre la très grande précision que nécessite ce domaine d'application.

Un autre inconvénient de cette technique de l'art antérieur est que, même avec des composants de grande qualité et de coût très élevé, il est difficile de maintenir un niveau de précision élevé dans le temps, à cause du vieillissement des composants.

Des techniques de calibration ont été proposées, pour limiter ces inconvénients (voir US 4013866). Toutefois, les phases de calibration supposent, selon ces techniques, l'interruption temporaire de l'émission, et donc du fonctionnement du capteur. Cette interruption n'est pas acceptable dans de nombreuses situations (diminution du rapport signal à bruit), et notamment dans le cas discuté ci-dessus d'équipements militaires, où le rapport signal à bruit doit être optimisé impérativement pour ainsi obtenir la précision maximale.

L'invention a notamment pour objectif de pallier ces inconvénients de l'art antérieur.

Plus précisément, un objectif de l'invention est de fournir une mesure de champ(s) magnétique(s) avec une grande précision, en conservant cette précision dans le temps et dans tout le domaine de température.

Un autre objectif de l'invention est d'obtenir une mesure de champ(s) magnétique(s) avec une grande précision avec des éléments à coût réduit, et notamment en mettant en oeuvre des résistances de qualité moyenne ou faible, ne présentant pas de spécification particulière de vieillissement, ni de conditions de dérives.

Encore un autre objectif de l'invention est de fournir un dispositif de mesure précise de champ(s) magnétique (s) qui puisse fonctionner de manière continue et qui ne nécessite pas de phase préliminaire et/ou périodique de calibration, pendant laquelle la mesure est interrompue.

Ces objectifs, ainsi que d'autres qui apparaîtront par la suite sont atteints selon l'invention, à l'aide d'un dispositif de mesure de champ(s) magnétique(s), comprenant au moins une chaîne d'acquisition de mesure constituée d'un générateur de courant de mesure, d'une bobine, d'une résistance de mesure, d'au moins un amplificateur et d'au moins un filtre anti-repliement délivrant une tension de mesure, comprenant des moyens de détermination d'au moins une grandeur électrique représentative de ladite chaîne d'acquisition, lesdits moyens de détermination comprenant des moyens d'injection d'un courant de calibration prédéterminé, comportant au moins deux termes fréquentiels à au moins deux fréquences distinctes de celle(s) dudit courant de mesure, ledit courant de calibration se superposant audit courant de mesure, et des moyens de calcul délivrant une estimation de ladite au moins une grandeur électrique à la ou les fréquence(s) dudit courant de mesure.

Ainsi, l'invention repose sur une approche tout à fait nouvelle et inventive de la calibration, mise en oeuvre de manière continue (sans interruption de la mesure), qui n'influe pas sur la mesure effectuée à court terme, et qui améliore considérablement la précision à long ou moyen terme.

En effet, l'invention repose sur la détermination d'une estimation d'au moins une grandeur électrique représentative de la chaîne de mesure, à partir des paramètres de calibration, de manière à éliminer les incertitudes de mesure et/ou la dépendance de la mesure à des paramètres lentement variables, connus avec une précision insuffisante ou inconnus, comme par exemple les résistances de mesure du courant et les fonctions de transfert des chaînes de mesure.

L'invention met donc en oeuvre des signaux de calibration, qui se superposent aux signaux à mesurer, et qui présentent des composantes spectrales à des fréquences distinctes de celle des signaux utiles. On peut ainsi facilement calculer une estimation d'une grandeur électrique représentative de la chaîne de mesure à la ou les fréquence(s) des signaux de mesure.

Selon une caractéristique avantageuse de l'invention, les moyens d'injection du courant de calibration sont mis en oeuvre au cours d'un cycle de calibration, dans au moins deux chaînes d'acquisition de mesure distinctes.

Avantageusement, une grandeur électrique représentative de la chaîne d'acquisition est la fonction de transfert ou la tension de sortie de calibration de la chaîne (cette tension étant la tension de sortie de la chaîne d'acquisition lorsqu'on impose en entrée un courant (ou une tension) de calibration).

Par cycle de calibration, on entend une série d'injections du courant de calibration séquentiellement, sur les voies des différentes chaînes d'acquisition, en superposition au courant de mesure. Le terme " cycle de calibration " ne désigne pas ici la phase de calibration spécifique avec arrêt de l'émission, tel que connue et utilisée dans l'art antérieur. En effet, la présente invention propose la mise en oeuvre d'une calibration continue (sans interruption de la mesure), pour laquelle le courant de calibration est injecté pendant la mesure de la voie calibrée.

On peut donc calibrer au moins deux chaînes d'acquisition distinctes en injectant un unique courant de calibration successivement dans chacune des chaînes, et en ne mettant en oeuvre qu'un seul dispositif de génération du courant de calibration.

Selon une variante avantageuse de l'invention, les moyens d'injection du courant de calibration sont mis en oeuvre, au cours d'un cycle de calibration, d'une part dans un émetteur de champ(s) magnétique(s), et d'autre part dans un capteur de champ(s) magnétique(s).

Dans ce cas, avantageusement, l'émetteur et le capteur définissant un repère dans l'espace comprennent chacun 3 chaînes d'acquisition, des moyens de traitement permettant de déterminer la position et/ou l'orientation du capteur par rapport à l'émetteur.

Cette caractéristique de l'invention est particulièrement avantageuse pour la détermination de l'orientation d'un système mobile par rapport à un référentiel, et notamment pour les viseurs de casques utilisés dans les avions d'armes ou les hélicoptères de combat, qui constituent un domaine d'application privilégié de l'invention. En effet, l'analyse des champs magnétiques émis par l'émetteur et mesurés par le capteur permet de déterminer la position et l'orientation du trièdre mobile du capteur par rapport au trièdre fixe de l'émetteur.

De façon avantageuse, les moyens d'injection du courant de calibration sont mis en oeuvre successivement dans chacune desdites chaînes d'acquisition au cours du cycle de calibration.

Par cycle de calibration, on entend donc ici l'injection du courant de calibration séquentiellement sur les 6 voies (respectivement 3 voies pour l'émetteur et 3 voies pour le capteur) en superposition au courant de contre-réaction du capteur ou au courant d'émission de l'émetteur. A nouveau, le terme " cycle de calibration " ne désigne pas une phase de calibration spécifique avec arrêt de l'émission, telle que décrite dans l'art antérieur. Le courant de calibration est, au contraire, injecté pendant la mesure de la voie calibrée, sans interruption de la mesure.

Selon une caractéristique avantageuse de l'invention, les moyens d'injection du courant de calibration mettent en oeuvre un générateur de courant de très grande impédance interne commandé par une tension de référence de calibration et alimentant une résistance de génération du courant de calibration, la résistance et la tension de référence étant constantes pendant la durée d'un cycle de calibration.

Ainsi, le courant d'entrée de calibration qui se superpose, après injection dans les chaînes d'acquisition, aux courants de mesure a une valeur constante et égale à $V_{cal}/R_{cal}$ pendant toute la durée d'un cycle de calibration. Il est donc le même pour chacune des voies, respectivement de mesure pour le capteur, et d'émission pour l'émetteur. Cette caractéristique de l'invention permet donc un traitement simplifié, lors de la mise en oeuvre des moyens de calcul de l'estimation des fonctions de transfert et/ou des tensions de sortie de calibration des différentes chaînes d'acquisition.

Selon un mode de réalisation préférentiel de l'invention, les moyens de calcul mis en oeuvre selon l'invention effectuent au moins certaines des opérations suivantes :

- mesure de la tension de mesure correspondant aux fréquences du courant de calibration ;
- estimation de la tension de sortie de calibration à la ou les fréquence(s) de mesure ;
- détermination d'une estimation d'une grandeur électrique représentative de la chaîne d'acquisition ;
- détermination d'une relation entre l'estimation de la grandeur électrique représentative de la chaîne d'acquisition, la tension de mesure, le courant de mesure, la résistance de mesure, la résistance de calibration, le courant de calibration et la tension de référence de calibration ;
- calcul d'une matrice $3\times3$ des rapports des courants de mesure du capteur sur les courants de mesure de l'émetteur.

L'obtention de cette matrice permet d'avoir facilement accès à la matrice de rotation du référentiel lié au capteur par rapport au référentiel lié à l'émetteur, et conduit donc à la détermination de la position et de l'orientation du capteur dans le référentiel lié à l'émetteur.

Selon une technique avantageuse de l'invention, les moyens de calcul permettant d'obtenir une estimation de la tension de calibration ou de la fonction de transfert à la ou les fréquence(s) de mesure peuvent mettre en oeuvre des traitements tels que l'interpolation polynomiale ou la régression multiple linéaire (c'est-à-dire l'estimation de la valeur optimale au sens des moindres carrés des paramètres d'une fonction polynomiale ou non polynomiale). Plus généralement, l'invention peut également mettre en oeuvre toute technique permettant d'obtenir une estimation des paramètres optimaux de la fonction de transfert à la ou les fréquence(s) de mesure, à partir des valeurs des fonctions de transfert aux fréquences des signaux de calibration. Cela s'applique aussi au modèle de la tension de sortie de calibration pour la ou les fréquence(s) de mesure à partir des valeurs de cette tension de sortie aux fréquences de calibration.

Avantageusement, dans au moins certaines des chaînes d'acquisition, la résistance de mesure est remplacée par une résistance de mesure unique commune auxdites au moins certaines chaînes d'acquisition.

L'invention permet notamment de réaliser un émetteur dans lequel les trois résistances de chacune des trois voies sont regroupées en une résistance unique, ce qui est particulièrement intéressant pour la réalisation industrielle de l'invention.

L'invention concerne également un procédé de mesure de champ(s) magnétique(s), mettant en oeuvre au moins une chaîne d'acquisition de mesure comprenant un générateur de courant de mesure, une bobine, une résistance de mesure, au moins un amplificateur, et au moins un filtre antirepliement, délivrant une tension de mesure, et mettant en oeuvre :

- une étape de détermination d'au moins une grandeur électrique représentative de ladite chaîne d'acquisition, comprenant une étape d'injection d'un courant d'entrée de calibration prédéterminé, comportant au moins deux termes fréquentiels à au moins deux fréquences distinctes de celle(s) dudit courant de mesure, ledit courant d'entrée de calibration se superposant audit courant de mesure,
- une étape de calcul délivrant une estimation de ladite au moins une grandeur électrique à la ou les fréquence(s) dudit courant de mesure.

La présente invention peut avantageusement trouver des applications dans de nombreux domaines, et notamment dans l'un au moins des domaines suivants :

- boussoles de précision utilisées pour la mesure du cap magnétique en navigation ;
- capteurs fluxmètres asservis ;
- détermination de la position et de l'orientation d'un mobile en déplacement (translation et/ou rotation) dans un référentiel, par exemple pour un viseur de casque en aviation ;
- détection de masses magnétiques en mouvement relatif par rapport à un capteur ;
- mesures métrologiques de champs magnétiques ;
- mesures dans un environnement thermique variable.

Plus généralement, l'invention peut trouver des applications dans tous les domaines où il est nécessaire de réaliser des mesures de champ(s) magnétique(s) très précises, et notamment des mesures tri-axes. L'invention peut aussi être mise en oeuvre dans des équipements de mesure de champ(s) magnétique(s) destinés à avoir d'importantes durées de vie. En effet, le procédé et le dispositif mis en oeuvre selon l'invention offrent l'assurance d'un effet négligeable du vieillissement des composants de toutes les chaînes de mesure et d'acquisition.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente un capteur magnétique comprenant trois bobines sensiblement orthogonales, et une bobine émettrice d'une induction (parmi les trois bobines constitutives d'un émetteur), selon le dispositif mis en oeuvre dans un viseur de casque ;
- la figure 2 illustre les chaînes d'acquisition de mesure et les moyens de calibration mis en oeuvre selon l'invention pour améliorer la précision de la mesure effectuée dans le système présenté en figure 1 ;
- la figure 3 présente le principe de la méthode de détermination d'une estimation de la fonction de transfert d'une chaîne d'acquisition de mesure présentée sur la figure 2 ;
- la figure 4 présente un synoptique du dispositif mis en oeuvre dans un viseur de casque, comprenant le capteur et l'émetteur présentés en figure 1, les chaînes d'acquisition de mesure et les moyens de calibration illustrés en figure 2, et les moyens de calcul de la fonction de transfert, selon la figure 3.

Le principe général de l'invention repose sur la superposition de signaux de calibration aux signaux utiles à mesurer, le domaine de fréquences des signaux de calibration étant disjoint du domaine de fréquences des signaux de mesure.

Un domaine d'application privilégié de la présente invention est la détermination d'une orientation liée à un système mobile, par exemple à un viseur de casque utilisé dans les avions d'armes ou les hélicoptères de combat.

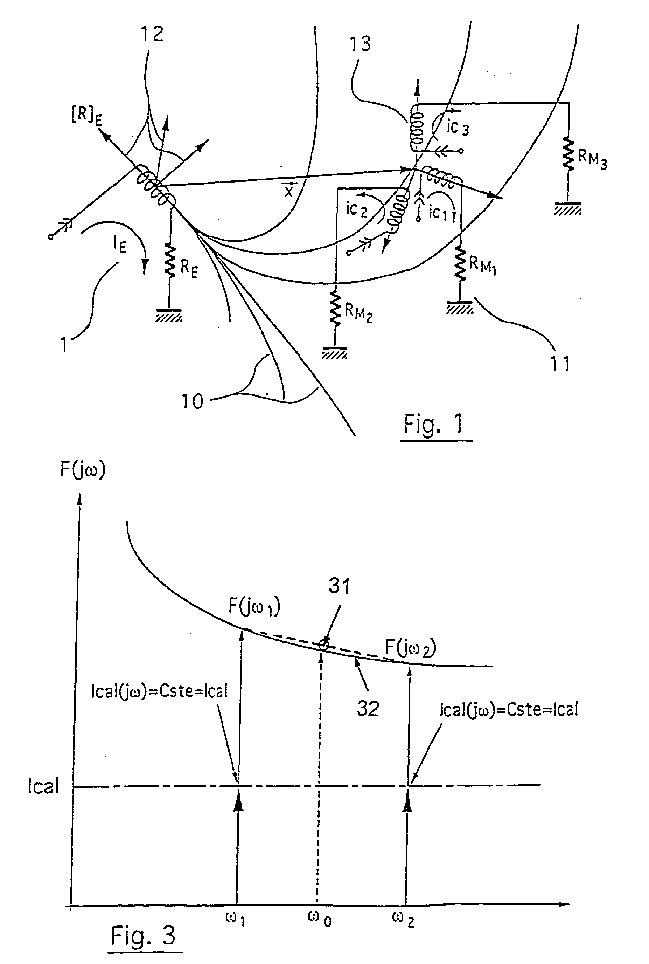

On présente, en relation avec les figures 1 à 4, un mode de réalisation d'un dispositif de mesure de champ(s) magnétique(s) mettant en oeuvre des moyens de calibration continue, pour un viseur de casque.

Comme mentionné précédemment, un dispositif de mesure d'orientation et de position du casque du pilote dans un repère lié à l'aéronef peut consister en un capteur de mesure d'orientation et de la position constitué de trois bobines électromagnétiques orthogonales et placé sur le casque, et en un émetteur, situé en un point fixe de la cabine, et constitué de trois autres bobines électromagnétiques.

L'objet de la mesure mise en oeuvre selon la figure 1 consiste donc à déterminer la position et l'orientation d'un capteur magnétique 11 dans le repère orthonormé $[R]_E$ 12 formé par les 3 bobines d'un émetteur 1 de champ magnétique $\vec{B}_E(\vec{x})$. On notera que, par souci de clarté et de simplification, seule une bobine d'émission a été représentée sur la figure 1. La généralisation à trois bobines est immédiate.

Au point $\vec{x}$, qui indique la position du capteur 11 dans le repère $[R]_E$, l'induction $\vec{B}_E(\vec{x})$ se projette sur les 3 axes des bobines de détection et de contre-réaction 13 du capteur. Les courants de contre-réaction $i_{c1}$, $i_{c2}$ et $i_{c3}$ mis en oeuvre dans le capteur 11 annulent ces projections, par un procédé d'asservissement connu de l'homme du métier. $i_{c1}$, $i_{c2}$ et $i_{c3}$ représentent donc les mesures d'induction magnétique selon les directions des axes du capteur.

En effet, pour une émission sur une seule bobine telle que représentée sur la figure 1, il est connu qu'en un point $\vec{x}$ de l'espace, pour un émetteur orthonormé et un capteur orthonormé, le capteur 11 mesure :

$$\begin{pmatrix} i_{c1} \\ i_{c2} \\ i_{c3} \end{pmatrix} = k \left[ R'_{C/E} \right] \begin{pmatrix} f_1(\vec{x}) \\ f_2(\vec{x}) \\ f_3(\vec{x}) \end{pmatrix} i_E \qquad (1)$$

où $R'_{C/E}$ est la matrice transposée de la matrice de passage du référentiel émetteur vers le référentiel capteur, formée des vecteurs unitaires des axes capteur exprimés dans le référentiel émetteur, et k un terme de proportionnalité dépendant des unités choisies, $f_1(\vec{x})$, $f_2(\vec{x})$, $f_3(\vec{x})$ étant les composantes de $\vec{B}_E(\vec{x})$ au point $\vec{x}$ dans le référentiel 12 $[R]_E$ formé par l'émetteur 1 pour un courant d'émission unité.

En faisant les rapports $\dfrac{i_{c1}}{i_E}, \dfrac{i_{c2}}{i_E}, \dfrac{i_{c3}}{i_E}$ (où $i_E$ est le courant d'émission), il ne reste que l'information de position $\vec{x}$ et de rotation X, Y, Z du capteur 11 dans l'expression de la mesure (1) ci-dessus. Dans le cas plus général de trois émissions selon les trois axes de l'émetteur, l'obtention de la matrice $3 \times 3$ de terme générique $i_{ci}/i_{Ej}$, où i et j sont des indices de valeur 1 à 3, donne donc aisément accès à l'orientation et à la position du capteur 11 dans le référentiel 12 de l'émetteur 1.

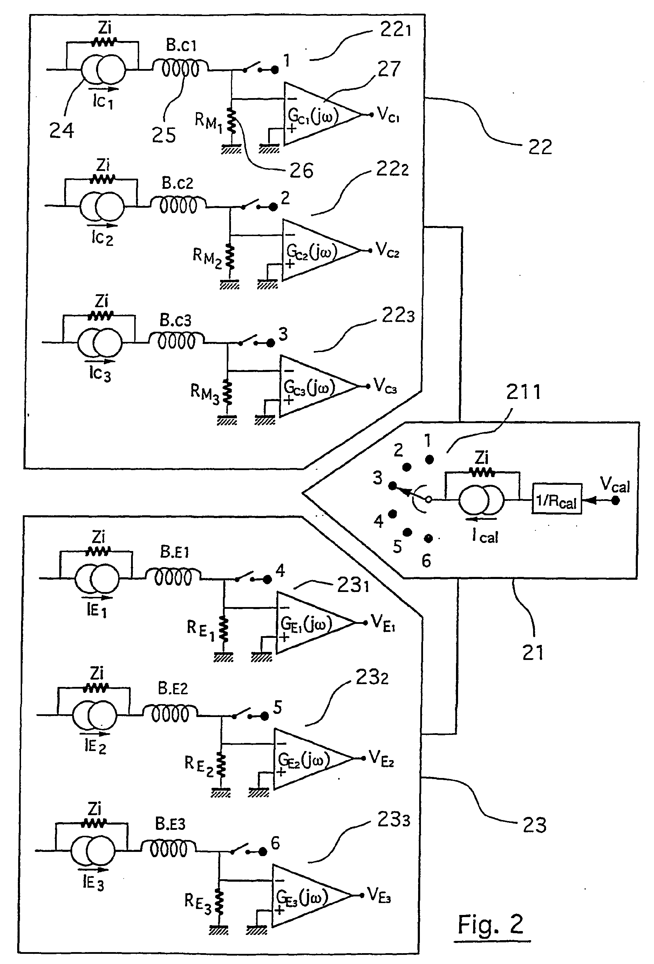

Selon l'invention, la mesure des courants $i_{c1}$, $i_{c2}$, $i_{c3}$ et $i_{Ej}$ peut être faite avec précision en mettant en oeuvre une calibration dont le schéma simplifié est illustré en figure 2.

On a représenté, schématiquement, les trois chaînes $22_1$ à $22_3$ du capteur, et les trois chaînes $23_1$ à $23_3$ de l'émetteur. Chaque chaîne présente un générateur de courant 24, d'impédance $Z_i$ quasi infinie, une bobine 25, une borne (numérotée de 1 à 6) de connexion avec le module de calibration 21, une résistance 26 ($R_{Mi}$ ou $R_{Ei}$) et un amplificateur 27 délivrant respectivement les tensions $V_{ci}$ et $V_{Ei}$. Le module 21 de calibration comprend une résistance $R_{cal}$ et un générateur de courant $I_{cal}$, d'impédance interne $Z_i$ quasi infinie. Des moyens de répartition 211 injectent alternativement sur les bornes 1 à 6 des résistances $R_{M1}$, $R_{M2}$, $R_{M3}$, $R_{E1}$, $R_{E2}$, et $R_{E3}$ un courant $I_{cal} = V_{cal}/ R_{cal}$ qui se superpose aux courants à mesurer $i_{c1}$, $i_{c2}$, $i_{c3}$, dans le capteur, et $i_{E1}$, $i_{E2}$, $i_{E3}$ dans l'émetteur.

Afin de ne pas perturber la mesure de ces courants, on dispose de générateurs de courant 24, dans la boucle de contre-réaction du capteur d'une part, et dans chacune des chaînes d'émission de l'émetteur d'autre part. La caractéristique principale de ces générateurs de courant est d'avoir une impédance interne $Z_i$ quasi infinie. Ainsi, le courant de calibration s'ajoute dans les résistances $R_{M1}$, $R_{M2}$ et $R_{M3}$ aux courants de mesure sans erreurs et sans perturber la contre-réaction du capteur. De la même façon, le courant de calibration s'ajoute sans perturbation aux courants d'émission dans les résistances $R_{E1}$, $R_{E2}$ et $R_{E3}$.

Pour une chaîne d'émission, on a donc :

$$\dot{V}_E = G_E(\omega)R_E(i_E + i_{cal})$$

Par ailleurs, le domaine de fréquences du signal de calibration est, selon l'invention, disjoint du domaine de fréquences des courants d'émission dans l'antenne d'émission. Une manière de réaliser la calibration est, par exemple, d'injecter un courant dont les caractéristiques fréquentielles sont les suivantes : le courant $i_{cal}$ comporte uniquement des termes fréquentiels à différentes pulsations $\omega_i$ alors que le courant de mesure est à une pulsation $\omega_0$ ou à des pulsations $\omega_{0j} \neq \omega_i$.

$i_E$ et $i_{cal}$ sont séparés fréquentiellement ( par exemple par FFT (en anglais "Fast Fourier Transform ") ou par détection synchrone) et l'expression pour toutes les tensions mesurées est alors du type:

$$V_E^{(1)} = G_E(\omega_0)R_E i_E$$

et

$$V_E^{(2)} = G_E(\omega_i)R_E i_{cal}$$

On en déduit alors la fonction de transfert estimée $G_E(\omega)^*R_E$ à la pulsation émise $\omega_0$ de façon connue, par une estimation polynomiale par exemple dans le domaine fréquentiel, d'où $\dfrac{i_E}{i_{cal}} \cong \dfrac{V_E^{(1)}(\omega_0)}{\hat{V}_E^{(2)}(\omega_0)}$ dans lequel $\hat{V}_E^{(2)}(\omega_0)$ est l'estimé de

$V_E^{(2)}$ pour la fréquence de $i_E$, à l'erreur près faite sur l'estimation de $R_E G_E(\omega_0) = \dfrac{V_E^{(2)}}{i_{cal}}$.

On peut aussi estimer $V^{(2)}{}_E(\omega_0)$ noté $\hat{V}_E^{(2)}(\omega_0)$ par modélisation polynomiale de façon analogue à partir de valeurs $V^{(2)}{}_E(\omega_i)$ pour au moins deux valeurs $\omega_i$ :

$$V_E^{(2)}(\omega_i) \rightarrow \hat{V}_E^{(2)}(\omega_0) = f(R_E G_E(\omega_i)i_{cal})$$
$$= \widehat{R_E G_E}(\omega_0)i_{cal}$$

avec $i_{cal}(\omega) = $ constante $= i_{cal}$

où $\widehat{R_E G_E}$ est une fonction d'approximation dont on estime les paramètres de façon optimale par interpolation ou par identification par les moindres carrés, de façon connue. $\overset{\overset{\wedge}{\frown}}{R_E G_E}$ est une fonction linéaire ou une fonction non linéaire du type des : fonctions de transfert habituelles $\dfrac{N(\omega)}{D(\omega)}$ où $N(\omega)$ et $D(\omega)$ sont des polynômes en $\omega$ d'ordres n et p avec n≤p.

Par ailleurs, $V_E^{(1)}(\omega_0) = R_E G_E(\omega_0) i_E(\omega_0)$ d'où

$$\frac{V_E^{(1)}(\omega_0)}{\hat{V}_E^{(2)}(\omega_0)} \,\#\, \frac{i_E(\omega_0)}{i_{cal}}$$

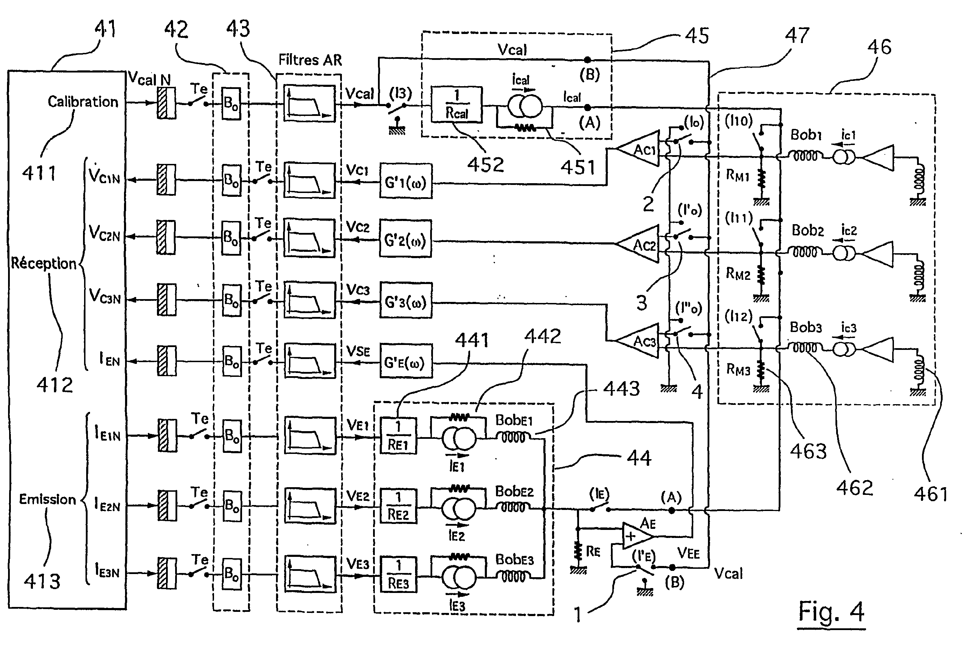

La figure 3 présente la méthode permettant d'accéder à l'estimation, par exemple par interpolation linéaire, de la fonction de transfert ou de la tension de sortie de calibration $\hat{V}_E^{(2)}(\omega_0)$, à la fréquence émise, dans le cas particulier où le courant de calibration comporte uniquement deux termes fréquentiels, l'un à $\omega_1$ et l'autre à $\omega_2$ alors que le courant de mesure est à $\omega_0$. On adopte la notation $F(j\omega)=R_E*G(j\omega)$, où $j = \sqrt{-1}$. F peut également représenter à $i_{cal}$ près la tension de calibration $\hat{V}_E^{(2)}$. Sur la figure 3, 31 représente la fonction $F(j\omega_0)$ interpolée linéairement, et 32 représenté $F(j\omega_0)$ identifiée par une fonction non-linéaire.

On peut procéder, pour le courant de mesure dans les chaînes d'acquisition du capteur de la même façon que pour le courant d'émission :

$V_C = G_c(\omega).R_M(i_c + i_{cal})$, égalité de laquelle on déduit, après séparation fréquentielle:

$$V_c^{(1)}(\omega_0) \rightarrow V_c^{(1)}(\omega_0) = G_c(\omega_0).R_M i_c(\omega_0)$$

$$V_c^{(2)}(\omega_0) \rightarrow V_c^{(2)}(\omega_i) = G_c(\omega_i).R_M i_{cal}(\omega_i)$$

À partir de plusieurs pulsations $\omega_i$, on estime la valeur de $\hat{V}_c(\omega_0) = f(G_c(\omega_i)R_M i_{cal}(\omega_i))$ :

$$\hat{V}_c(\omega_0) = \hat{G}_c(\omega_0) R_M i_{cal}(\omega_0)$$

avec :

$$i_{cal}(\omega_i) = i_{cal} = \text{constante } \forall i.$$

Zn évaluant le rapport:

$$\frac{V_c(\omega_0)}{\hat{V}_c(\omega_0)} = \frac{G_c(\omega_0) R_M i_c(\omega_0)}{\hat{G}_c(\omega_0) R_M i_{cal}(\omega_0)} \approx \frac{i_c(\omega_0)}{i_{cal}}$$

à l'erreur d'estimation près de $\hat{G}(\omega_0)$.

On peut alors évaluer le rapport suivant :

$$\left(\frac{i_c}{i_{cal}}\right)\bigg/\left(\frac{i_E}{i_{cal}}\right) = \frac{i_c}{i_E} = \frac{V_c(\omega_0)}{\hat{V}_c(\omega_0)}\frac{\hat{V}_E(\omega_0)}{V_E(\omega_0)} \qquad (2)$$

et on remarque que si les chaînes d'acquisition de l'émetteur et du capteur sont sensiblement identiques, $\dfrac{\hat{V}_E(\omega_0)}{\hat{V}_c(\omega_0)}$

est sensiblement constant dans le domaine de fréquences utile. Cela n'est pas nécessaire, mais facilite la précision.

On peut par ailleurs noter que $G_{E(j)}$ et $G_{c(i)}$ sont en fait des fonctions complexes de $(j\omega)$ : $G_{E(j)}(j\omega)$ et $G_{c(i)}(j\omega)$.

Les mesures calibrées de l'équation (2) ne dépendent donc plus de la tension de référence de calibration $V_{cal}$, ni de la résistance $R_{cal}$ de génération du courant de calibration à condition que ces deux grandeurs soient constantes pendant la durée du cycle de calibration.

Par ailleurs, les mesures ne dépendent plus des résistances de mesure des courants ($R_{Mi}$ et $R_{Ej}$) ni des fonctions de transfert d'acquisition des voies de mesures capteur $G_{Cj}$ ou de mesure du courant $G_{Ej}$.

On obtient donc, selon l'invention, des mesures calibrées des rapports $i_{ci}/i_{Ej}$, qui permettent de déterminer, avec précision, la position et l'orientation du capteur placé sur le casque du pilote, dans le référentiel lié à l'émetteur fixé dans l'aéronef.

On adopte préférentiellement le mode de réalisation consistant à estimer la tension de calibration à la ou les fréquence(s) de mesure, de préférence au mode de réalisation consistant à estimer la fonction de transfert à la ou les fréquence(s) de mesure. En effet, le modèle de la mesure exact s'écrit :

$$V_s(j\omega) = R_m.G_m(j\omega).\big[i_m(j\omega) + i_{cal}(j\omega) + i_b(j\omega)\big] + b_n(j\omega)$$

où $i_b(j\omega)$ est un bruit de courant,

$b_n(j\omega)$ est un bruit de tension de la chaîne de mesure,

$V_s(j\omega)$ est la tension de sortie de l'une des chaînes $22_1$ à $22_3$ et $23_1$ à $23_3$ représentées sur la figure 2 ($V_s(j\omega)$ désigne donc l'une quelconque des tensions $V_{c1}$ à $V_{c3}$ et $V_{E1}$ à $V_{E3}$ de la figure 2),

et l'indice m est un terme générique pour désigner la chaîne d'émission (indice E) ou la chaîne du capteur (indice c).

$i_b(j\omega)$ doit être décomposé: - en bruit de courant du générateur de courant à mesurer ($i_{Ej}$ ou $i_{ci}$), soit $i_{b-m}(j\omega)$ (pour $i_{b-c}$ et $i_{b-E}$)

- et en bruit de courant du générateur de courant de calibration, soit $i_{b-cal}$.

  Tous les bruits peuvent être supposés localement blancs (c'est-à-dire que leur densité spectrale est constante dans les domaines de mesure et de calibration voisins).

Par conséquent, au cours d'un cycle de calibration, outre la série d'injections du courant de calibration séquentiellement, sur les voies des différentes chaînes d'acquisition, en superposition au courant de mesure, et les traitements associés précédemment évoqués, tels que la détermination d'une estimation de la fonction de transfert ou de la tension de calibration à la ou les fréquence(s) de mesure, d'autres traitements sont mis en oeuvre, tels que:

- le calcul du bruit en l'absence de courant de calibration; le circuit de calibration étant supposé ouvert et $V_{cal}$ injecté nul, sur les voies non calibrées à l'instant t, on a, aux fréquences de calibration:

$$V_{s-m}^{(0)}(j\omega_i) = R_m.G_m(j\omega_i)i_{b-m}(j\omega_i) + b_n(j\omega_i) \qquad (3)$$

On en déduit $\hat{V}_{s-m}^{(0)}(j\omega_0)$ par interpolation ou régression linéaire.

- le calcul du bruit du courant de calibration lorsque le circuit d'injection du courant est fermé sur la voie calibrée à l'instant t mais avec une valeur de $i_{cal}=0$ ($=V_{cal}/R_{cal}$). On a alors:

$$V_{s-cal}^{(0)}(j\omega_i) = R_m.G_m(j\omega_i)\left[i_{b-cal}(j\omega_i) + i_{b-m}(j\omega_i)\right] + b_n(j\omega_i)$$

Ainsi, au cours d'un cycle de calibration, on injecte un courant de calibration $i_{cal}$ séquentiellement, sur les voies des différentes chaînes d'acquisition, en superposition au courant de mesure, et on a:

$$V_{s-cal}(j\omega_i) = R_m.G_m(j\omega_i)\left[i_{b-cal}(j\omega_i) + i_{b-m}(j\omega_i) + i_{cal}(j\omega_i)\right] + b_n(j\omega_i)$$

On calcule alors:

$$V_{s-cal}^{*}(j\omega_i) = V_{s-cal}(j\omega_i) - V_{s-cal}^{(0)}(j\omega_i) \equiv R_m.G_m(j\omega_i)i_{cal}(j\omega_i)$$

D'après l'équation (2), pour la mesure des courants à mesurer:

$$V_{s-m}^{(0)}(j\omega_i) = R_m.G_m(j\omega_i)i_{b-m}(j\omega_i) + b_n(j\omega_i)$$

duquel on déduit:

$$\hat{V}_{s-m}^{(0)}(j\omega_0) = R_m.\hat{G}_m(j\omega_0)\hat{i}_{b-m}(j\omega_0) + \hat{b}_n(j\omega_0)$$

estimé.
On suppose:

- que $\hat{b}_n(j\omega_0) \# b_n(j\omega_i)$ $\forall\omega_i$ autour de $\omega_0$,
- et que $\hat{i}_{b-m}(j\omega_0) \# i_{b-m}(j\omega_i)$ $\forall\omega_i$ autour de $\omega_0$.

D'où $\hat{V}_{s-m}^{(0)}(j\omega_0) \# R_m.\hat{G}_m(j\omega_0)\hat{i}_{b-m}(j\omega_0) + \hat{b}_n(j\omega_0)$.

On calcule alors

$$V_{s-m}^{*}(j\omega_0) = V_{s-m}(j\omega_0) - \hat{V}_{s-m}^{(0)}(j\omega_0)$$

$$V_{s-m}^{*}(j\omega_0) = R_m.G_m(j\omega_0)i_m(j\omega_0)$$
$$+ R_m.G_m(j\omega_0)i_{b-m}(j\omega_0) - R_m.\hat{G}_m(j\omega_0)\hat{i}_{b-m}(j\omega_0)$$
$$+ b_n(j\omega_0) - \hat{b}_n(j\omega_0)$$

d'où

$$V_{s-m}^{*}(j\omega_0) \# R_m G_m(j\omega_0)i_m(j\omega_0)$$

Pour tenir compte du bruit, il faut donc substituer, dans les traitements précédents permettant d'accéder à la matrice $3\times3$ de terme générique $i_{ci}/i_{Ej}$, $V_E^{*(1)}(\omega_0)$ et $V_c^{*(1)}(\omega_0)$, calculés selon une technique similaire à celle employée pour le calcul de

$V_{s-m}^{*}$, respectivement à $V_E^{(1)}(\omega_0)$ et $V_c^{(1)}(\omega_0)$.

De même, on remplace $V_E^{(2)}(\omega_i)$ et $V_c^{(2)}(\omega_i)$ par $V_E^{*(2)}(\omega_i)$ et $V_c^{*(2)}(\omega_i)$, qu'on utilise pour déduire les relations :

$$\hat{V}_E^{*(2)}(\omega_0) \equiv \hat{V}_{E-cal}^{*}(\omega_0)$$

et

$$\hat{V}_c^{*(2)}(\omega_0) \equiv \hat{V}_{c-cal}^{*}(\omega_0)$$

On aboutit ainsi à la formule (2).

La figure 4 présente un synoptique du dispositif global mis en oeuvre dans un viseur de casque. On ne discute pas en détail les différents éléments constitutifs de ce dispositif, ceux-ci étant soit connus, soit discutés précédemment.

On notera cependant qu'un tel dispositif comprend un calculateur d'acquisition et de traitement 41, qui gère les signaux de calibration 411, les signaux de mesure en réception 412 et les signaux d'émission 413, soit quatre voies en réception et quatre voies en émission. Chaque voie comprend des moyens d'échantillonnage des signaux à la période $T_E$, un bloqueur d'ordre zéro 42, et un filtre anti-repliement 43.

Un émetteur de champ magnétique 44 comprend 3 chaînes d'acquisition numérotées de 1 à 3 constituées d'un générateur de courant 442, d'une bobine d'émission 443 et d'une conductance 441. Les trois bobines d'émission 443 sont reliées en un point commun $P_c$ sur lequel se somment les trois courants $i_{E1}$, $i_{E2}$, $i_{E3}$. La tension $V_{EE}$ vaut $R_E$. ( $i_{E1} + i_{E2} + i_{E3}$). Cette méthode est rendue possible par le fait que l'impédance $Z_i$ des trois générateurs de courant 442 tend vers l'infini: $Z_i >> 1000.R_E$. Cette réalisation permet de simplifier la mise en oeuvre de l'électronique de mesure du courant d'émission. En effet, il n'y a plus qu'une seule résistance $R_E$ et une seule fonction de transfert $G_E(\omega)$. Une telle réalisation permet également de réduire la complexité et la durée du cycle de calibration.

Un capteur magnétique 46 comprend 3 chaînes d'acquisition de mesure numérotées de 1 à 3 comprenant une bobine de détection 461, une bobine de contre-réaction 462 et une résistance de mesure 463. Le signal de calibration $I_{cal}$ est généré à l'aide d'un dispositif comprenant un générateur de courant de calibration 451 et une résistance de calibration 452.

Le dispositif comprend encore un circuit de tension de calibration 47. Une telle tension de calibration permet, si elle est prévue dans le cycle de calibration, de mesurer le rapport R/$R_{cal}$, R désignant l'une quelconque des résistances $R_E$, $R_{M1}$, $R_{M2}$, et $R_{M3}$. Ceci permet de contrôler la dérive des rapports $\dfrac{R_{Mi}}{R_E}$ entre les résistances.

En négligeant les bruits, le principe de la mesure est alors le suivant: aux fréquences dites de calibration $\omega_i$, on a:

- pour $i_{cal}$=0 et $V_{cal}\neq$0 aux entrées $A_E$, $A_{c1}$, $A_{c2}$, $A_{c3}$ séquentiellement ou non, on a:

$$V_{E-cal}^{V}(\omega_i) = G_E(\omega_i)V_{cal}(\omega_i) = G_E(\omega_i)R_{cal}i_{cal}(\omega_i) \qquad (4)$$

- pour $i_{cal}\neq$0 et $V_{cal}$=0 aux entrées $A_E$, $A_{c1}$, $A_{c2}$, $A_{c3}$ séquentiellement ou non, sur les points 1, 2, 3, 4 de la figure 4 séquentiellement, on a:

$$V_{E-cal}^{i}(\omega_i) = G_E(\omega_i)R_E i_{cal}(\omega_i).$$

En calculant le rapport $\dfrac{V_{E\text{-}cal}^{i}}{V_{E\text{-}cal}^{v}}$, on en déduit $R_E/R_{cal}$.

On procèderait de la même façon pour $\dfrac{R_{M1}}{R_{cal}}$, $\dfrac{R_{M2}}{R_{cal}}$, $\dfrac{R_{M3}}{R_{cal}}$.

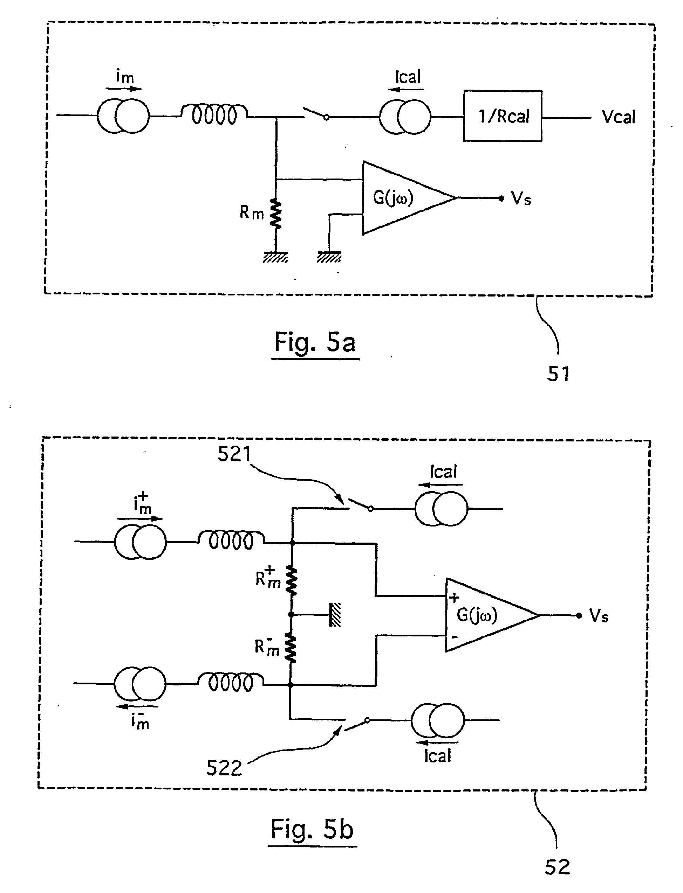

On notera que la description des différents modes de réalisation de l'invention a été illustrée à l'aide de schémas non différentiels, tel que le schéma 51 de la figure 5a. L'invention s'applique bien sûr également à des schémas différentiels tels que le schéma 52 de la figure 5b. Les injections de courant aux points 521 et 522 se font alors, par exemple, séquentiellement dans le temps.

Dans les figures 5a et 5b, le courant $i_m$ désigne l'un quelconque des courants $i_{ci}$ ou $i_{Ej}$, la résistance $R_m$, l'une quelconque des résistances $R_{ci}$ ou $R_{Ej}$, et la tension $V_s$, l'une quelconque des tensions $V_{ci}$ ou $V_{Ej}$.

On notera également que l'évaluation de $R_E/R_{cal}$ permet, si $R_{cal}$ est une résistance de précision, de surveiller la valeur de $R_E$. On peut ainsi mettre plusieurs résistances $R'_E$ de même valeur en parallèle $\dfrac{1}{R_E} = \sum_{i} \dfrac{1}{R'_{E_i}}$. Cette mise en parallèle permet d'augmenter les valeurs de $R'_E$, de diminuer leur spécification de tenue en puissance, ce qui est favorable. L'augmentation de l'imprécision et de la dérive est compensée par le procédé de calibration, objet de la présente invention.

**Revendications**

1. Dispositif de mesure de champ magnétique, comprenant au moins une chaîne d'acquisition de mesure ($22_1$, $22_2$, $22_3$; $23_1$, $23_2$, $23_3$) comprenant un générateur de courant de mesure (24 ; 442), une bobine (13 ; 25 ; 443, 461, 462), une résistance de mesure (26 ; 463), au moins un amplificateur (27) et au moins un filtre antirepliement (43), délivrant une tension de mesure,
**caractérisé en ce qu'**il comprend des moyens de détermination d'au moins une grandeur électrique représentative de ladite chaîne d'acquisition, lesdits moyens de détermination comprenant des moyens d'injection (21) d'un courant de calibration prédéterminé, comportant au moins deux termes fréquentiels à au moins deux fréquences distinctes de celle ou celles dudit courant de mesure, ledit courant de calibration se superposant audit courant de mesure, et des moyens de calcul délivrant une estimation de ladite au moins une grandeur électrique à la ou les fréquences dudit courant de mesure.

2. Dispositif selon la revendication 1, **caractérisé en ce que** ladite au moins une grandeur électrique représentative de ladite chaîne d'acquisition appartient au groupe comprenant:

   - la fonction de transfert de ladite chaîne d'acquisition;
   - une tension de sortie de calibration de ladite chaîne d'acquisition.

3. Dispositif selon l'une quelconque des revendications 1 et 2, **caractérisé en ce que** lesdits moyens d'injection dudit courant de calibration sont mis en oeuvre au cours d'un cycle de calibration, dans au moins deux chaînes d'acquisition de mesure distinctes.

4. Dispositif selon l'une quelconque des revendications 1 à 3, **caractérisé en ce que** lesdits moyens d'injection dudit courant de calibration sont mis en oeuvre au cours d'un cycle de calibration, d'une part dans un émetteur de champ magnétique (1 ; 44), et d'autre part dans un capteur de champ magnétique (11 ; 46).

5. Dispositif selon la revendication 4, **caractérisé en ce que** ledit émetteur et ledit capteur définissant un repère dans l'espace comprennent chacun 3 chaînes d'acquisition, des moyens de traitement permettant de déterminer la position et l'orientation dudit capteur par rapport audit émetteur.

6. Dispositif selon l'une quelconque des revendications 3 à 5, **caractérisé en ce que** lesdits moyens d'injection dudit courant de calibration sont mis en oeuvre successivement dans chacune desdites chaînes d'acquisition au cours dudit cycle de calibration.

**7.** Dispositif selon l'une quelconque des revendications 3 à 6, **caractérisé en ce que** lesdits moyens d'injection dudit courant de calibration mettent en oeuvre un générateur de courant (451) de très grande impédance interne commandé par une tension de référence de calibration et alimentant une résistance (452) de génération du courant de calibration, ladite résistance et ladite tension de référence étant constantes pendant la durée d'un cycle de calibration.

**8.** Dispositif selon la revendication 7, **caractérisé en ce que** lesdits moyens de calcul effectuent au moins certaines des opérations suivantes :

- mesure de la tension de mesure correspondant aux fréquences du courant de calibration ;
- estimation de la tension de sortie de calibration à la ou les fréquences de mesure ;
- détermination d'une estimation d'une grandeur électrique représentative de ladite chaîne d'acquisition ;
- détermination d'une relation entre ladite estimation de ladite grandeur électrique représentative, ladite tension de mesure, ledit courant de mesure, ladite résistance de mesure, ladite résistance de calibration, ledit courant de calibration et ladite tension de référence de calibration ;
- calcul d'une matrice $3\times3$ des rapports des courants de mesure dudit capteur sur les courants de mesure dudit émetteur.

**9.** Dispositif selon l'une quelconque des revendications 1 à 8, **caractérisé en ce que** lesdits moyens de calcul mettent en oeuvre l'un au moins des éléments du groupe comprenant :

- interpolation polynomiale ;
- régression multiple linéaire.

**10.** Dispositif selon l'une quelconque des revendications 3 à 9, **caractérisé en ce que**, dans au moins certaines desdites au moins deux chaînes d'acquisition, ladite résistance de mesure est remplacée par une résistance de mesure unique commune auxdites au moins certaines chaînes d'acquisition.

**11.** Procédé de mesure de champ magnétique mettant en oeuvre au moins une chaîne d'acquisition de mesure comprenant un générateur de courant de mesure, une bobine, une résistance de mesure, au moins un amplificateur, et au moins un filtre antirepliement délivrant une tension de mesure,
**caractérisé en ce qu'**il met en oeuvre :

- une étape de détermination d'au moins une grandeur électrique représentative de ladite chaîne d'acquisition, comprenant une étape d'injection d'un courant de calibration prédéterminé, comportant au moins deux termes fréquentiels à au moins deux fréquences distinctes de celle ou celles dudit courant de mesure, ledit courant de calibration se superposant audit courant de mesure,
- une étape de calcul délivrant une estimation de ladite au moins une grandeur électrique à la ou les fréquences dudit courant de mesure.

**12.** Application du dispositif selon l'une quelconque des revendications 1 à 9, ou du procédé selon la revendication 10, à l'un au moins des domaines suivants :

- boussoles de précision utilisées pour la mesure du cap magnétique en navigation ;
- capteurs fluxmètres asservis ;
- détermination de la position et de l'orientation d'un mobile en déplacement, i.e. translation et/ou rotation, dans un référentiel, par exemple pour un viseur de casque en aviation;
- détection de masses magnétiques en mouvement relatif par rapport à un capteur ;
- mesures métrologiques de champs magnétiques ;
- mesures dans un environnement thermique variable.

**Claims**

**1.** Device for measuring magnetic fields, comprising at least one measurement acquisition pathway ($22_1$, $22_2$, $22_3$; $23_1$, $23_2$, $23_3$) comprising a measurement current generator (24; 442), a coil (13; 25; 443, 461, 462), a measurement resistor (26; 463), at least one amplifier (27) and at least one antialiasing filter (43), delivering a measurement voltage, **characterized in that** it comprises means for determination of at least one electrical quantity representative of said acquisition pathway, said means of determination comprising means of injection (21) of a predetermined calibration current, comprising at least two frequency terms at at least two frequencies distinct from that or those of said measurement current, said calibration current being superimposed on said measurement current, and calculation means delivering an estimate of said at least one electrical quantity at the frequency or frequencies of said measurement current.

2. Device according to Claim 1, **characterized in that** said at least one electrical quantity representative of said acquisition pathway belongs to the group comprising:

   - the transfer function of said acquisition pathway;
   - a calibration output voltage of said acquisition pathway.

3. Device according to either of Claims 1 and 2, **characterized in that** said means of injection of said calibration current are implemented in the course of a calibration cycle, in at least two distinct measurement acquisition pathways.

4. Device according to any one of Claims 1 to 3, **characterized in that** said means of injection of said calibration current are implemented in the course of a calibration cycle, on the one hand in an emitter of magnetic fields (1; 44), and on the other hand in a sensor of magnetic fields (11; 46).

5. Device according to Claim 4, **characterized in that** said emitter and said sensor defining a reference frame in space each comprise three acquisition pathways, processing means making it possible to determine the position and the orientation of said sensor with respect to said emitter.

6. Device according to any one of Claims 3 to 5, **characterized in that** said means of injection of said calibration current are implemented successively in each of said acquisition pathways in the course of said calibration cycle.

7. Device according to any one of Claims 3 to 6, **characterized in that** said means of injection of said calibration current implement a current generator (451) of very large internal impedance controlled by a calibration reference voltage and energizing a calibration current generation resistor (452), said resistor and said reference voltage being constant for the duration of a calibration cycle.

8. Device according to Claim 7, **characterized in that** said calculation means perform at least some of the following operations:

   - measurement of the measurement voltage corresponding to the frequencies of the calibration current;
   - estimation of the calibration output voltage at the measurement frequency or frequencies;
   - determination of an estimate of an electrical quantity representative of said acquisition pathway;
   - determination of a relation between said estimate of said representative electrical quantity, said measurement voltage, said measurement current, said measurement resistance, said calibration resistance, said calibration current and said calibration reference voltage;
   - calculation of a $3 \times 3$ matrix of the ratios of the measurement currents of said sensor to the measurement currents of said emitter.

9. Device according to any one of Claims 1 to 8, **characterized in that** said calculation means implement one at least of the elements of the group comprising:

   - polynomial interpolation;
   - multiple linear regression.

10. Device according to any one of Claims 3 to 9, **characterized in that**, in at least some of said at least two acquisition pathways, said measurement resistor is replaced with a single measurement resistor common to said at least some acquisition pathways.

11. Process for measuring magnetic fields, implementing at least one measurement acquisition pathway comprising a measurement current generator, a coil, a measurement resistor, at least one amplifier, and at least one antialiasing filter delivering a measurement voltage, **characterized in that** it implements:

   - a step of determination of at least one electrical quantity representative of said acquisition pathway, comprising a step of injection of a predetermined calibration current, comprising at least two frequency terms at at least two frequencies distinct from that or those of said measurement current, said calibration current being superimposed on said measurement current,

- a step of calculation delivering an estimate of said at least one electrical quantity at the frequency or frequencies of said measurement current.

12. Application of the device according to any one of Claims 1 to 9, or of the process according to Claim 10, to at least one of the following domains:

- precision compasses used for measuring the magnetic heading in navigation;
- servocontrolled fluxmeter sensors;
- determination of the position and of the orientation of a mobile craft moving, i.e. translation and/or rotation in a frame of reference, for example for a helmet viewfinder in aviation;
- detection of magnetic masses in relative motion with respect to a sensor;
- metrological measurements of magnetic fields;
- measurements in a variable thermal environment.

**Patentansprüche**

1. Vorrichtung zur Messung von Magnetfeldern mit mindestens einer Messerfassungskette ($22_1$, $22_2$, $22_3$; $23_1$, $23_2$, $23_3$) , die einen Messstromgenerator (24; 442), eine Spule (13; 25; 443, 461, 462), einen Messwiderstand (26; 463), mindestens einen Verstärker (27) und mindestens ein Anti-Aliasing-Filter (43) aufweist, das eine Messspannung liefert,

   **dadurch gekennzeichnet, dass** sie Mittel zur Bestimmung mindestens einer für die Erfassungskette repräsentativen elektrischen Größe, wobei die Bestimmungsmittel Mittel (21) zum Einspeisen eines vorbestimmten Kalibrierstroms mit mindestens zwei Frequenztermen auf mindestens zwei Frequenzen unterschiedlich von derjenigen oder denjenigen des Messstroms aufweisen, wobei der Kalibrierstrom den Messstrom überlagert, und Rechenmittel aufweist, die einen Schätzwert der mindestens einen elektrischen Größe mit der oder den Frequenzen des Messstroms liefern.

2. Vorrichtung nach Anspruch 1, **dadurch gekennzeichnet, dass** die mindestens eine für die Erfassungskette repräsentative elektrische Größe zu der Gruppe gehört, die aufweist:

   - die Transferfunktion der Erfassungskette;
   - eine Ausgangskalibrierspannung der Erfassungskette.

3. Vorrichtung nach einem der Ansprüche 1 und 2, **dadurch gekennzeichnet, dass** die Mittel zum Einspeisen des Kalibrierstroms während eines Kalibrierzyklus in mindestens zwei unterschiedlichen Messerfassungsketten angewendet werden.

4. Vorrichtung nach einem der Ansprüche 1 bis 3, **dadurch gekennzeichnet, dass** die Mittel zum Einspeisen des Kalibrierstroms während eines Kalibrierzyklus einerseits in einem Magnetfeldemitter (1; 44) und andererseits in einem Magnetfeldsensor (11; 46) angewendet werden.

5. Vorrichtung nach Anspruch 4, **dadurch gekennzeichnet, dass** der Emitter und der Sensor, die ein räumliches Bezugssystem definieren, je 3 Erfassungsketten enthalten, wobei Verarbeitungsmittel es ermöglichen, die Position und die Ausrichtung des Sensors bezüglich des Emitters zu bestimmen.

6. Vorrichtung nach einem der Ansprüche 3 bis 5, **dadurch gekennzeichnet, dass** die Mittel zum Einspeisen des Kalibrierstroms nacheinander in jeder der Erfassungsketten während des Kalibrierzyklus angewendet werden.

7. Vorrichtung nach einem der Ansprüche 3 bis 6, **dadurch gekennzeichnet, dass** die Mittel zum Einspeisen des Kalibrierstroms einen Stromgenerator (451) sehr großer Innenimpedanz anwenden, der von einer Kalibrierbezugsspannung gesteuert wird, und einen Widerstand (452) zur Erzeugung des Kalibrierstroms speisen, wobei der Widerstand und die Bezugsspannung während der Dauer eines Kalibrierzyklus konstant sind.

8. Vorrichtung nach Anspruch 7, **dadurch gekennzeichnet, dass** die Rechenmittel mindestens bestimmte der nachfolgenden Operationen ausführen:

- Messung der Messspannung entsprechend den Frequenzen des Kalibrierstroms;
- Schätzung der Kalibrierausgangsspannung auf der oder den Messfrequenzen;
- Bestimmung eines Schätzwerts einer für die Erfassungskette repräsentativen elektrischen Größe;
- Bestimmung einer Beziehung zwischen dem Schätzwert der repräsentativen elektrischen Größe, der Messspannung, dem Messstrom, dem Messwiderstand, dem Kalibrierwiderstand, dem Kalibrierstrom und der Kalibrierbezugsspannung;
- Berechnung einer 3x3-Matrix der Verhältnisse der Messströme des Sensors zu den Messströmen des Emitters.

9. Vorrichtung nach einem der Ansprüche 1 bis 8, **dadurch gekennzeichnet, dass** die Rechenmittel mindestens eines der Elemente der Gruppe verwenden, die aufweist:

- polynomiale Interpolation;
- lineare Mehrfachregression.

10. Vorrichtung nach einem der Ansprüche 3 bis 9, **dadurch gekennzeichnet, dass** in mindestens bestimmten der mindestens zwei Erfassungsketten der Messwiderstand durch einen einzigen, den mindestens bestimmten Erfassungsketten gemeinsamen Messwiderstand ersetzt wird.

11. Verfahren zur Messung von Magnetfeldern, das mindestens eine Messerfassungskette anwendet, die einen Stromgenerator, eine Spule, einen Messwiderstand, mindestens einen Verstärker und mindestens ein Anti-Aliasing-Filter aufweist, das eine Messspannung liefert,
**dadurch gekennzeichnet, dass** es anwendet:

- einen Schritt der Bestimmung mindestens einer für die Erfassungskette repräsentativen elektrischen Größe, der einen Schritt des Einspeisens eines vorbestimmten Kalibrierstroms mit mindestens zwei Frequenztermen auf mindestens zwei Frequenzen unterschiedlich von derjenigen oder denjenigen des Messstroms aufweist, wobei der Kalibrierstrom den Messstrom überlagert,
- einen Rechenschritt, der einen Schätzwert der mindestens einen elektrischen Größe auf der oder den Frequenzen des Messstroms liefert.

12. Anwendung der Vorrichtung nach einem der Ansprüche 1 bis 9 oder des Verfahrens nach Anspruch 10 auf eines der folgenden Gebiete :

- Präzisionskompasse, die zur Messung des magnetischen Kurses in der Schifffahrt verwendet werden;
- geregelte Flussmesssensoren;
- Bestimmung der Position und der Ausrichtung eines beweglichen Objekts in Bewegung, d.h. in Translationsbewegung oder in Drehung, in einem Koordinatensystem, zum Beispiel für ein Helmsichtgerät in der Luftfahrt;
- Erfassung von Magnetmassen in relativer Bewegung bezüglich eines Sensors;
- metrologische Messungen von Magnetfeldern;
- Messungen in einer thermisch variablen Umgebung.

Fig. 1

Fig. 3

Fig. 2

Fig. 4

Fig. 5a

51

Fig. 5b

52